Europäisches Patentamt

(19) European Patent Office

Office européen des brevets

(11) Numéro de publication : **0 239 494 B1**

(12)  **FASCICULE DE BREVET EUROPEEN**

(45) Date de publication du fascicule du brevet :
14.08.91 Bulletin 91/33

(51) Int. Cl.⁵ : **H01L 23/48, H01L 23/04**

(21) Numéro de dépôt : 87400673.7

(22) Date de dépôt : 26.03.87

(54) Boîtier de circuit intégré.

(30) Priorité : 28.03.86 FR 8604500

(43) Date de publication de la demande :
30.09.87 Bulletin 87/40

(45) Mention de la délivrance du brevet :
14.08.91 Bulletin 91/33

(84) Etats contractants désignés :
CH DE ES FR GB IT LI NL SE

(56) Documents cités :
EP-A- 0 081 419
EP-A- 0 148 083
EP-A- 0 166 634
DE-A- 3 509 734
FR-A- 2 489 592
GB-A- 1 374 666
US-A- 3 696 323
US-A- 4 393 581
US-A- 4 396 935

(73) Titulaire : BULL S.A.
121 avenue de Malakoff P.B. 193.16
F-75764 Paris Cédex 16 (FR)

(72) Inventeur : Fontan, Jacques
9, La Guêpière
F-78120 Sonchamp (FR)
Inventeur : Dehaine, Gérard
92, rue Gay Lussac
F-92320 Chatillon (FR)
Inventeur : Kurzweil, Karel
37, allée de la forêt de Marly
F-78860 Saint-Nom-La-Breteche (FR)

(74) Mandataire : Denis, Hervé et al
BULL S.A. Industrial Property Department
P.C.: HQ 8M006 P.B. 193.16 121 avenue de
Malakoff
F-75764 Paris Cédex 16 (FR)

EP 0 239 494 B1

## Description

L'invention se rapporte à un boîtier de circuit intégré.

L'invention concerne tous les circuits intégrés et plus particulièrement les circuits intégrés de haute densité aussi appelés circuits intégrés VLSI (Very Large Scale Integration). Les circuits intégrés sont couramment appelés puces ou chips. Actuellement, les circuits intégrés de haute densité sont des plaquettes semiconductrices sensiblement carrées de plus d'un centimètre de coté et de moins d'un millimètre d'épaisseur. La face active d'une puce incorpore les circuits qui sont intégrés dans la plaquette et portent les plots d'entrée-sortie, tandis que la face opposée est appelée dos de la puce. La forte intégration des circuits entraîne ordinairement la présence de l'ordre de 500 plots sur la face active et la dissipation d'une forte densité de chaleur variable selon le type de fabrication des transistors intégrés. Par exemple, une puce de haute densité du type N-MOS (à transistors à effet de champ de type MOS(Métal-Oxyde-Semiconducteur) peut dissiper de l'ordre de quatre Watts.

D'une manière générale, on interconnecte plusieurs puces entre elles en les montant sur une carte de circuits imprimés. Le montage se pratique selon deux procédés bien connus. Le procédé le plus courant consiste à encapsuler chaque puce dans un boîtier et à souder les bornes du boîtier sur les plages correspondantes d'une carte de circuits imprimés. Les boîtiers offrent une bonne protection mécanique et sont facilement assemblés sur une carte, mais ils ont l'inconvénient d'être très encombrants et de limiter leur nombre sur une carte. Le second procédé remédie à cet inconvénient grâce à la connexion directe de chaque puce sur la carte. Cette technique est couramment appelée "micropackaging". Pour faciliter la manipulation des puces nues avant leur montage sur une carte, un procédé couramment appelé TAB (Tape-Automated Bonding) consiste à disposer les circuits intégrés sur un ruban porteur souple appelé ruban TAB. Chaque puce est pourvue de pattes prenant appui sur les bords d'une fenêtre ménagée dans le ruban. Les pattes de chaque puce sont découpées à l'intérieur de la fenêtre, puis sont soudées aux plages correspondantes d'une carte de circuits imprimés lors d'une opération dite OLB (Output Lead Bonding). De manière classique, le dos des puces repose sur la carte de circuits imprimés et leurs pattes sont précambrées pour venir en contact avec les plages de la carte et y être soudées par un outil de soudage OLB. Dans ce cas, l'évacuation des calories se fait à travers la carte. Selon un autre mode, appelé TAB inversé ou FLIP-TAB, le ruban est présenté de façon à disposer les faces actives des puces en regard de la carte. Les pattes des puces sont soudées sans cambrage préalable sur les plages de la carte et un élément d'évacuation de chaleur est appliqué au dos de chaque puce.

Le boîtier classique pour une puce VLSI est un boîtier à broches (pin-grid array package). Dans ce boîtier, le dos de la puce repose au fond d'une cavité ménagée sur une face d'une plaque de circuits imprimés multicouche et entourée de plusieurs rangées de broches perpendiculaires à la plaque. Les bords de la cavité sont disposés en gradins pourvus de plages destinées à la connexion avec les plots correspondants de la puce. Cette connexion est faite par fil (wire bonding). Le dos de la puce est en contact avec un élément d'évacuation de chaleur émergeant de l'autre face de la plaque pour être connecté à un dispositif de refroidissement tel qu'un radiateur. Le montage du boîtier sur une carte est de préférence fait par un connecteur ZIF (Zero-Insertion-Force). Les broches sont introduites sans force dans le connecteur et sont ensuite enserrées dans les éléments de contact du connecteur.

Le procédé de montage d'une puce sur une carte par l'intermédiaire d'un boîtier à broches présente en pratique de nombreux inconvénients. La plaque de circuits imprimés est un élément complexe, onéreux et à forte probabilité de défauts. Les éléments conducteurs des circuits imprimés sont répartis sur plusieurs plans, six par exemple, interconnectés entre plans adjacents par des piliers (vias). Ces éléments conducteurs sont très étroits pour s'accommoder à la haute densité requise par le grand nombre de plots de la puce. La disposition relative de ces éléments et des piliers correspondants doit donc être très précise pour assurer une connexion correcte en tout point. En pratique, cette condition est difficilement satisfaite et élève le coût d'une plaque. D'autre part, la connexion des plots de la puce aux plages de la cavité du boîtier est faite couramment par soudage de fils très minces, faits ordinairement d'or ou d'aluminium. Compte tenu de la haute densité des plots et de la répartition des plages en gradins, l'automatisation de la liaison par fils est compliquée et délicate. En résumé, le chemin moyen d'un plot d'une puce à une broche correspondante du boîtier fait intervenir deux soudures au niveau du fil reliant le plot à la plage correspondante du boîtier, des conducteurs minces et étroits réalisés en circuits imprimés dans la plaque multicouche, des piliers d'interconnexion des éléments conducteurs, et enfin la soudure du dernier élément conducteur avec la broche. Le boîtier équipé de la puce contient ainsi un très grand nombre de points de connexion, qui altère la fiabilité de l'ensemble et en accroît le coût. Enfin, le boîtier est monté sur un connecteur ZIF d'une carte de circuits imprimés. Ce connecteur a l'avantage d'être fiable et de fournir une connexion facilement amovible, mais présente l'inconvénient d'être encombrant et onéreux.

Le recours à la technique TAB pour la fabrication d'un boîtier a déjà été proposé dans le brevet français n° 2 456 390. Ce brevet met a profit la caractéristique essentielle du TAB qui est d'avoir chaque puce pourvue de son ensemble de pattes supporté par un ruban. Selon ce brevet, les extrémités des pattes découpées d'un ruban TAB constituent les bornes de sortie d'un boîtier simplement formé par l'enrobage de la puce et des parties adjacentes de ses pattes dans une résine électriquement isolante. La résine maintient en outre un élément d'évacuation de chaleur appliqué au dos de la puce. L'épaisseur de chaque patte est faible au voisinage de la puce et forte au-delà. La faible épaisseur procure aux pattes la souplesse requise pour le soudage uniforme et fiable de l'ensemble des pattes sur les plots de la puce, tandis que la forte épaisseur des pattes renforce notablement la rigidité de la résine du boîtier et procure la rigidité souhaitée aux bornes de sortie du boîtier.

Ce boîtier TAB ne convient qu'aux puces ayant un faible nombre de pattes. En effet, le boîtier n'est rigide que si les pattes sont elles-mêmes rigides. La rigidité est une condition essentielle d'un boîtier pour éviter toute cassure ou endommagement de la puce et de l'une de ses pattes. Le boîtier doit être d'autant plus rigide que la puce est de grande surface. Le renforcement de la rigidité de la résine ne peut être obtenu qu'en augmentant la section des pattes. Ceci n'est possible que si la densité des pattes est faible. Ce boîtier ne convient donc pas aux puces VLSI.

L'invention permet l'utilisation de la technique TAB pour le montage d'une puce sur une carte et la fabrication d'un boîtier adapté aux puces VLSI à haute densité de plots.

Un boîtier conforme à l'invention pour un circuit intégré, dont le dos est appliqué à un élément d'évacuation de chaleur et dont les pattes ont des parties d'extrémité libres constituant les bornes de sortie du boîtier et des parties intérieures fixées par un support isolant, est caractérisé par la nouvelle revendication 1

Les caractéristiques et avantages de l'invention ressortiront de la description qui suit, donnée à titre d'exemple et faite en référence aux dessins annexés.

Dans les dessins :
– la figure 1 est une vue en coupe suivant la ligne I-I de la figure 2, illustrant un circuit intégré monté sur une carte de circuits imprimés par l'intermédiaire d'un boîtier conforme à l'invention ;
– la figure 2 est une vue de dessus suivant la ligne II-II du boîtier représenté sur la figure 1,
– la figure 3 est une vue de dessus du support du boîtier représenté sur la figure 1 ;
– la figure 4 est une vue de dessus du capot du boîtier représenté sur la figure 1 ;
– la figure 5 est une vue partielle de dessus d'un ruban porteur de circuits intégrés pour la mise en oeuvre du boîtier de l'invention ;
– les figures 6A à 6H illustrent schématiquement des étapes du montage d'un circuit intégré du ruban de la figure 3 sur une carte de circuits imprimés, pour constituer le boîtier représenté sur la figure 1 ; et
– la figure 7 illustre par une vue analogue à celle de la figure 1 une variante de réalisation du boîtier conforme à l'invention.

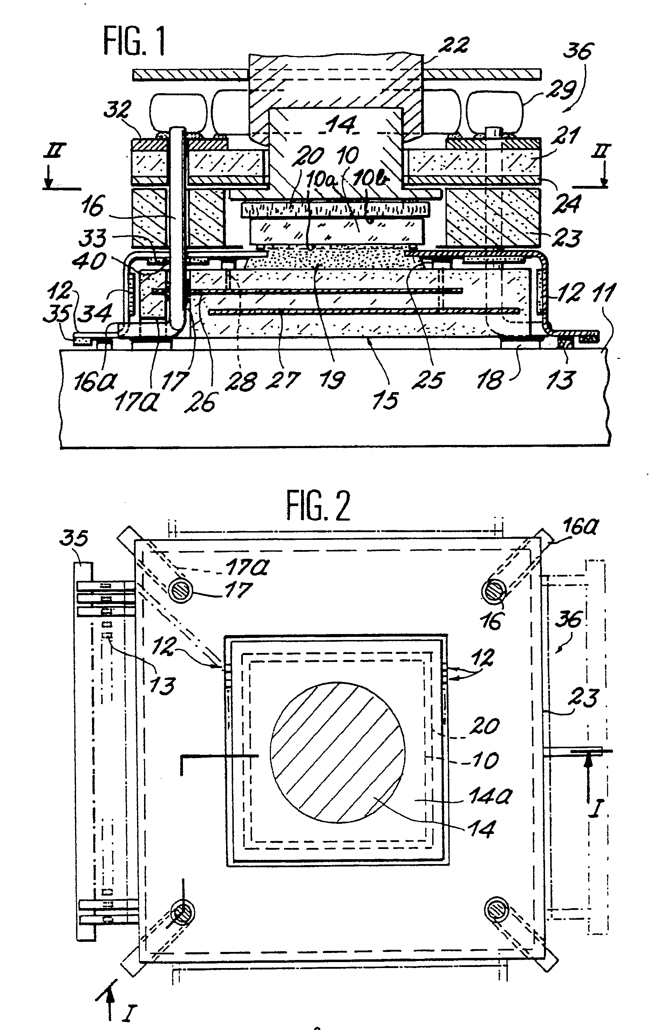

Les figures 1 et 2 illustrent un exemple conforme à l'invention de montage d'un circuit intégré ou puce (10) sur une carte de circuits imprimés (11). La puce (10) est du type présentant une face active (10a) pourvue de plots périphériques d'entrée-sortie connectés à des pattes rayonnantes (12), et une face arrière ou dos (10b). Pour mieux faire ressortir les caractéristiques de l'invention, on supposera par exemple que la puce (10) est une puce VLSI de type MOS d'un centimètre de côté, pourvue de cent pattes (12) par côté. On supposera aussi que l'alimentation électrique de la puce nécessite deux tensions (V1, V2) et que le dos (10b) de la puce (10) doit être connecté à la tension (V1), la masse par exemple. D'autre part, la carte (11) est pourvue de plages (13) pour le montage de la puce (10). Le procédé de montage est du type flip-tab, consistant à disposer la face active (10a) de la puce (10) en regard de la carte (11), à souder les extrémités des pattes (12) de la puce sur les plages correspondantes (13) de la carte et à appliquer un élément d'évacuation de chaleur (14) au dos (10b) de la puce (10). La réalisation du boîtier (10) conforme à l'invention consiste, préalablement au soudage, à disposer entre la carte (11) et la puce (10) associée à une partie adjacente de ses pattes (12) un support (15) pourvu d'au moins un élément conducteur (16) et à cambrer les pattes (12) à la périphérie du support pour placer les extrémités des pattes au niveau des plages correspondantes (13) de la carte (11). Dans l'exemple illustré, le support (15) est une plaque rigide, pourvue de quatre éléments conducteurs (16) se présentant sous la forme de colonnes rigides conductrices. Les colonnes (16) traversent le support (15) dans des trous (17) percés dans les quatre coins du support perpendiculairement à ses deux grandes faces. Chaque colonne (16) est coudée orthogonalement pour présenter une base (16a) dont la face inférieure est sensiblement coplanaire aux faces inférieures des extrémités des pattes (12). Un coudage analogue (17a) des trous (17) dans la partie basse du support (15) détermine le positionnement des colonnes par rapport au support. Selon l'invention, la carte (11) est pourvue de quatre bornes (18) pour la fixation des bases (16a) des colonnes (16). Dans l'exemple illustré, les quatre bornes (18) sont avantageusement couplées aux sources de tension (V1, V2) de manière que deux bornes adjacentes reçoivent des tensions différentes.

La face active de la puce est fixée au support (15) par une couche de colle (19). La puce (10) peut ainsi recevoir sans dommage l'élément d'évacuation de chaleur (14). L'élément (14) tel que représenté a la forme d'un rivet dont la tête carrée (14a) a approximativement les dimensions de la puce (10) pour être connectée avec elle par l'intermédiaire d'un élément d'interface souple (20). L'élément (20) peut être par exemple une mousse chargée de paillettes dont la nature et la disposition confèrent à la mousse une bonne conduction thermique. Le maintien du couplage entre l'élément (14) et la puce (10) est assuré par une plaque formant capot (21) fixée aux colonnes (16) et traversée par le corps cylindrique de l'élément (14). L'élément (14) peut ainsi être couplé avec un dispositif de refroidissement tel qu'un radiateur (22). Le radiateur (22) illustré a la forme d'un pilier massif bon conducteur thermique, monté par enfichage sur le corps cylindrique de l'élément (14) et pourvu d'ailettes transversales. La distance entre le capot (21) et le support (15) est déterminée par des éléments isolants d'entretoise (23) placés sur les pattes (12) de la puce (10). Les éléments d'entretoise illustrés (23) sont assemblés sous la forme d'un cadre entourant la puce (10), monté sur les colonnes (16) puis collé au capot (22). En variante, le cadre pourrait être solidaire du capot. De manière générale, l'élément d'évacuation de chaleur (14) doit être mis à la masse électrique de la carte (11), constituée par convention par la tension V1. L'invention offre l'avantage de faire cette connexion par l'intermédiaire d'au moins l'un des éléments conducteurs (16) qui est connecté à la borne (18) représentative de la tension V1. Dans l'exemple illustré, l'élément (14) est avantageusement relié aux deux colonnes (16) connectées aux bornes (18) représentatives de la tension V1, par l'intermédiaire d'une feuille conductrice (24) portée par la face inférieure du capot (21). La feuille conductrice (24) présente une couronne venant en contact avec la partie (14a) de l'élément (14) et se prolongeant pour entourer les deux colonnes (16) et permettre ainsi la liaison par soudure de la feuille (24) avec ces colonnes. La soudure tient aussi lieu de fixation mécanique du capot (21). Dans le cas présent où le dos (10b) de la puce (10) doit être mis à la masse, il suffit alors que l'élément d'interface thermique (20) soit aussi bon conducteur électrique.

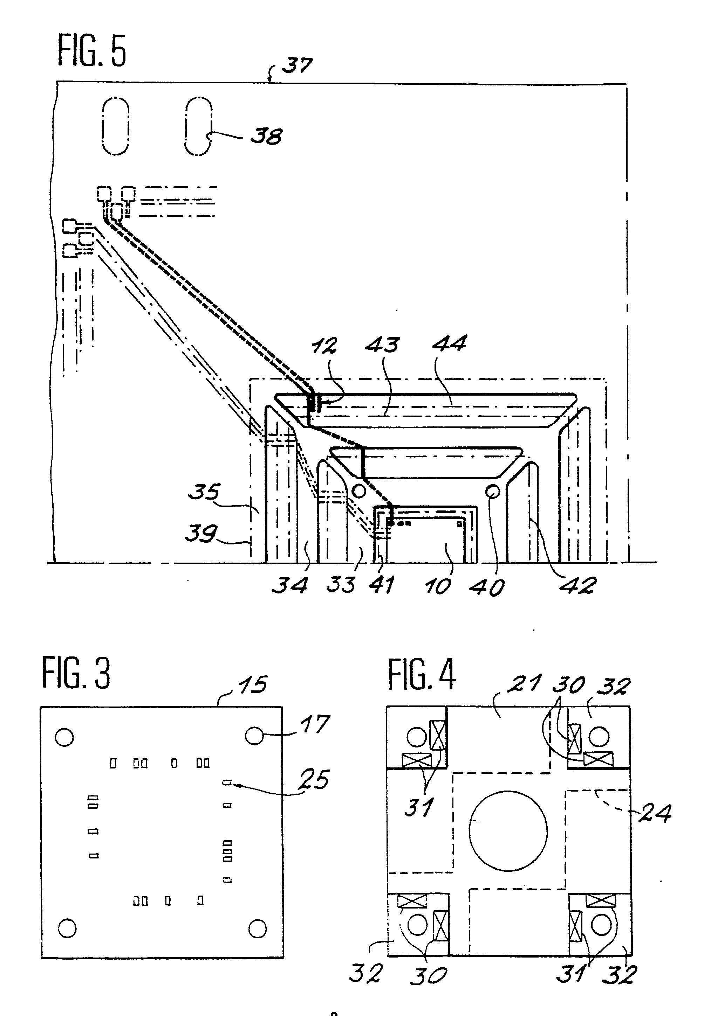

Comme représenté sur la figure 3, le support (15) présente sur sa face supérieure des îlots conducteurs (25) placés au voisinage de la puce (10) en correspondance avec des pattes (12) prédéterminées. Le support (15) est de manière générale une plaque de circuits imprimés destinés à connecter les îlots (25) à au moins l'une des sources de tension (V1, V2) par l'intermédiaire d'au moins un des éléments conducteurs (16) et des bornes correspondantes (18) de la carte (11). Dans l'exemple représenté sur la figure 1, le support (15) inclut deux plans conducteurs de circuits imprimés (26, 27) conformés pour être respectivement connectés aux colonnes (16) représentatives des tensions (V1, V2). La connexion des plans (26, 27) aux colonnes (16) correspondantes est faite dans l'exemple illustré par soudage d'extensions des plans (26, 27) autour des trous (17) recevant les colonnes (16). Des liaisons (28) relient les plans (26, 27) aux îlots (25) respectifs, par la technique des trous métallisés par exemple. L'alimentation de la puce (10) en tensions (V1, V2) se fait donc à proximité de la puce, à partir des îlots (25) jusqu'aux bornes (18). Ce trajet court-circuite les pattes (12) correspondantes et présente par conséquent une composante de self-induction plus atténuée. L'exemple illustré ajoute à cet avantage la possibilité d'un découplage par des condensateurs (29) au niveau des colonnes (16). Comme représenté sur la figure 4, la face supérieure du capot (21) est pourvue de quatre paires de plots (30, 31) destinées chacune à la fixation par soudure d'un condensateur (29). Les huit plots sont constitués par deux côtés adjacents de quatre plaquettes conductrices (32) placées dans les quatre coins du capot (21) autour des colonnes (16) et soudées à celles-ci. Les plots (30) reçoivent ainsi la tension V1 et les plots (31), la tension V2.

Compte tenu de la haute densité supposée des pattes (12) de la puce (10), leurs très faibles épaisseur et largeur les rendent très souples et très fragiles. Pour faciliter leur cambrage et leur soudage tout en évitant leur déformation et les court-circuits entre elles, elles sont de préférence maintenues en position en les fixant, par collage par exemple, sur des cadres de support souples électriquement isolants. Dans l'exemple illustré, un cadre interne (33) est disposé pour se placer sur le support (15) entre les îlots (25) et les bords du support. Un cadre intermédiaire (34) vient se placer sur les flancs du support (15), et un cadre externe (35) fixe les extémités des pattes (12) au-delà des plages (13). L'ensemble représenté sur la figure 2 et soudé sur la carte (11) de la manière illustrée dans la figure 1 constitue un boîtier (36) pour la puce (10).

La configuration de la puce (10), de ses pattes (12) et des cadres (33-35) est bien appropriée à la technique du ruban TAB. La figure 5 illustre une vue de dessus d'une partie d'un ruban TAB (37) relative à une seule puce (10) pouvant servir au montage dans le boîtier (36) représenté sur les figures 1 et 2. Pour des raisons de symétrie, la figure 5 ne représente qu'une moitié du ruban (37) par rapport à sa ligne médiane longitudinale. De manière classique, le ruban TAB (37) est pourvu de perforations latérales (38) pour son positionnement précis. Les pattes (12) de la puce (10) commencent par prendre appui sur le cadre (33), puis sur le cadre (34) et s'étalent ensuite sur le ruban (37) jusqu'au voisinage des perforations (38). Le cadre (36) est formé par découpe du ruban (37) selon la ligne (39) représentée par un trait tireté. Des trous (40) sont ménagés aux quatre coins du cadre (33) pour le passage des colonnes (16) de façon à positionner précisément la puce (10) et ses pattes (12) par rapport aux colonnes. On a représenté sur la figure 5 par un trait fantôme la ligne (41) suivant laquelle les ilôts (25) sont alignés et sont soudés aux pattes (12), les lignes (42) et (43) suivant lesquelles les pattes (12) sont pliées sur les parois latérales du support (15) pour être au niveau des plages (13) de la carte (11), et la ligne (44) suivant laquelle les pattes (12) sont soudées aux plages (13).

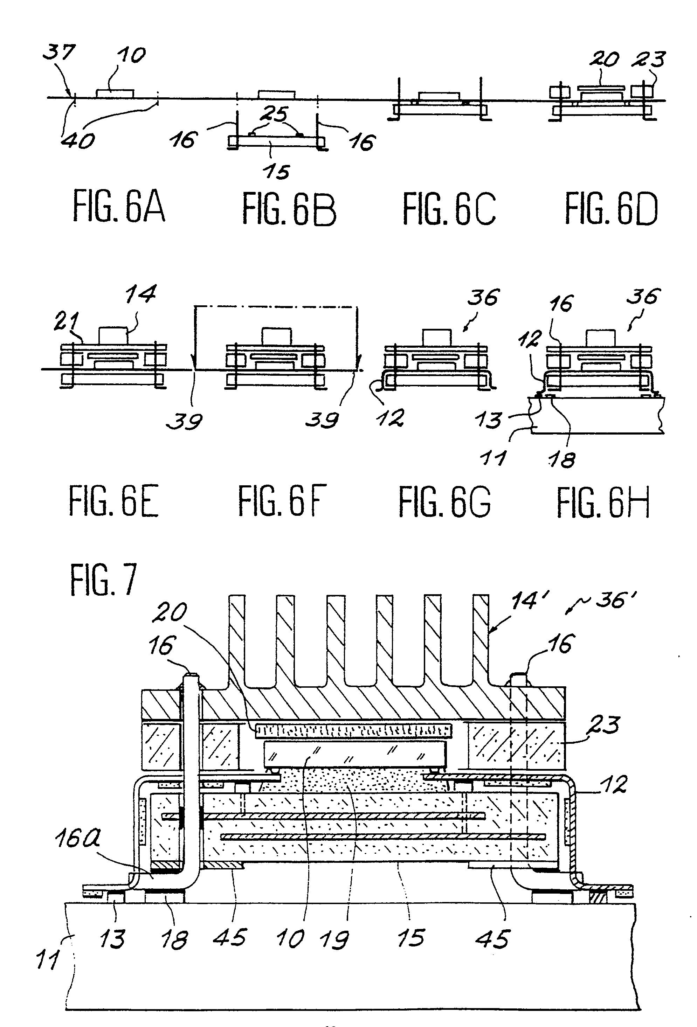

Les figures 6A à 6H illustrent schématiquement des étapes pour le montage final, tel que représenté sur la figure 1, du circuit intégré (10) du ruban (37) sur la carte de circuits imprimés (11). La figure 6A correspond au ruban (37) tel que représenté sur la figure 5. A la figure 6B, le support (15) pourvu des quatre colonnes (16) est placé sous le ruban (37). Les trous (40) du ruban (37) et les colonnes (16) du support (15) servent de points de référence pour le positionnement du support par rapport au ruban. A la figure 6C, le support (16) est fixé au ruban par la mise en correspondance des colonnes (16) avec les trous (40) du ruban (37) et par le soudage des ilôts (25) aux pattes correspondantes (12) de la puce (10). A la figure 6D, le cadre-entretoise (23) est enfiché dans les colonnes (16) et éventuellement collé sur les pattes (12), par l'intermédiaire d'une membrane adhésive par exemple. L'élément d'interface thermique (20) est posé sur le dos (10b) de la puce (10). A la figure 6E, le capot (21) pourvu de l'élément d'évacuation de chaleur (14) et des condensateurs de découplage (29) est enfiché dans les colonnes (16) et fixé à celles-ci, par une colle conductrice ou par soudure par exemple. A la figure 6F, le redan (37) est découpé suivant la ligne (39) pour détacher la puce (10) du ruban. A la figure 6G, les pattes (12) sont cambrées suivant les lignes (42) ou (43) de la figure 5. On obtient ainsi le boîtier (36). A la figure 6H, le boîtier (36) est monté sur la carte (11) par soudage des extrémités des pattes (12) aux plages (13) de la carte (11). Le soudage est avantageusement fait selon la technique OLB précitée.

La figure 7 illustre par une vue analogue à celle de la figure 1 une variante de réalisation du boîtier (36') conforme à l'invention. Dans ce boîtier, les éléments similaires à ceux du boîtier (36) portent les mêmes chiffres de référence. Une première différence réside dans le fait que l'élément d'évacuation de chaleur (14) dans le boîtier (36') est un radiateur mis à la place du radiateur (22), de l'élément d'évacuation de chaleur (14), du capot (21) et de sa feuille conductrice (24) dans le boîtier (36) de la figure 1. Le radiateur (14') est connecté mécaniquement et électriquement aux deux colonnes (16) représentatives de la tension (V1), tandis qu'éventuellement il peut être connecté seulement mécaniquement aux deux autres colonnes. Une seconde différence dans la variante de la figure 7 réside dans le positionnement des colonnes (16) sur le support (15). Les bases (16a) sont ici fixées, par soudage par exemple, à des pièces métalliques (45) fixées aux quatre coins inférieurs du support.

## Revendications

1. Boîtier (36, 36') pour un circuit intégré (10) pourvu des pattes, le dos (10b) du circuit intégré (10) étant appliqué à un élément d'évacuation de chaleur (14, 14') et les pattes (12) du circuit intégré (10) ayant des parties d'extrémité libres constituant les bornes de sortie du boîtier et des parties intérieures fixées par un support isolant (15), caractérisé en ce que le support (15) est une plaque rigide de circuits imprimés, qui est disposée vis-à-vis de la face active (10a) du circuit intégré (10) et fixée à l'élément d'évacuation de chaleur (14) par l'intermédiaire d'un cadre-entretoise (23) électriquement isolant entourant le circuit intégré, et qui présente des îlots (25) en correspondance respective avec des pattes prédéterminées (12) du circuit intégré (10) et connecte les îlots (25) à au moins une source de tension d'alimentation (V1, V2) extérieure au boîtier, par l'intermédiaire d'au moins un élément conducteur (16).

2. Boîtier selon la revendication 1, caractérisé en ce que le support (15) est pourvu de deux plans conducteurs (26, 27) connectés à des éléments conducteurs (16) respectifs.

3. Boîtier selon la revendication 2, caractérisé en ce que les îlots (25) sont soudés aux pattes respectives du circuit intégré.

4. Boîtier selon la revendication 1, 2 ou 3, caractérisé en ce que l'élément conducteur (16) est connecté électriquement à l'élément d'évacuation de chaleur (14).

5. Boîtier selon la revendication 4, caractérisé en ce que la fixation de l'élément d'évacuation de chaleur (14) comprend en outre sa connexion électrique à l'élément conducteur (16).

6. Boîtier selon l'une des revendications 1 à 5, caractérisé en ce que le cadre-entretoise (23) porte un capot (21) comprenant une feuille conductrice (24) mettant en liaison électrique l'élément d'évacuation de chaleur (14) avec au moins un élément conducteur (16) du support (15).

7. Boîtier selon la revendication 6, caractérisé en ce que le support (15) est fixé à l'élément d'évacuation de chaleur (14) par l'intermédiaire du cadre-entretoise (23) et du capot (21).

8. Boîtier selon l'une des revendications 1 à 7, caractérisé en ce qu'il comprend en outre un découplage par des condensateurs (29) au niveau des éléments conducteurs (16).

9. Boîtier selon la revendication 8, caractérisé en ce que le capot (21) porte des paires de plots (30, 31) destinées chacune à la fixation d'un condensateur de découplage (29), les plots (30, 31) de chaque paire étant connectés respectivement à deux éléments conducteurs (16) du support (15).

10. Boîtier selon la revendication 9, caractérisé en ce que les plots (30, 31) sont formés par deux côtés adjacents de plaquettes conductrices (32) disposées aux coins du capot (21) et fixées chacune à un élément conducteur (16) du support (15).

11. Boîtier selon l'une des revendications 1 à 10, caractérisé en ce que chaque élément conducteur (16) est une colonne traversant le support (15).

12. Boîtier selon la revendication 11, caractérisé en ce que chaque colonne (16) traverse le support (15) dans un trou (17) et est pourvue d'une base coudée (16a) dont la face inférieure est sensiblement coplanaire avec les extrémités des pattes (12).

13. Boîtier selon l'une des revendications 1 à 12, caractérisé en ce que les pattes (12) du circuit intégré (10) sont maintenues en position par au moins un cadre isolant (33 - 35).

14. Boîtier selon la revendication 13, caractérisé en ce qu'un cadre (35) fixe les extrémités libres des pattes (12).

15. Boîtier selon la revendication 13, caractérisé en ce qu'un cadre (33) comporte des trous (40) coopérant avec des éléments conducteurs (16) pour positionner les pattes (12) du circuit intégré (10) par rapport au support (15).

16. Boîtier selon la revendication 13, caractérisé en ce que le circuit intégré est détaché par découpage d'un ruban TAB.

17. Boîtier selon l'une des revendications 1 à 16, caractérisé en ce qu'un élément d'interface souple, bon conducteur thermique (20) est disposé entre le dos (10b) du circuit intégré (10) et l'élément d'évacuation de chaleur (14).

18. Boîtier selon la revendication 17, caractérisé en ce que l'élément d'interface est aussi bon conducteur électrique.

**Patentansprüche**

1. Gehäuse (36, 36') für eine mit Anschlußleitungen versehene integrierte Schaltung (10), wobei die Rückseite (10b) der integrierten Schaltung (10) auf ein Wärmeabführelement (14, 14') aufgebracht ist und die Anschlußleitungen (12) der integrierten Schaltung (10) freie Endbereiche, die die Ausgangsanschlüsse des Gehäuses bilden, und an einem Isolierträger (15) befestigte Innenbereiche besitzen, dadurch gekennzeichnet, daß der Träger (15) eine starre Platte mit gedruckten Schaltungen ist, die gegenüber der aktiven Seite (10a) der integrierten Schaltung (10) angeordnet ist, über einen die integrierte Schaltung umgebenden, elektrisch isolierenden Versteifungsrahmen (23) am Wärmeabführelement (14) befestigt ist, in jeweiliger Entsprechung mit vorgegebenen Anschlußleitungen (12) der integrierten Schaltung (10) kleine Blöcke (25) aufweist und die kleinen Blöcke (25) über wenigstens ein dazwischengeschaltetes Leiterelement (16) mit wenigstens einer Versorgungsspannungsquelle (V1, V2) verbindet.

2. Gehäuse gemäß Anspruch 1, dadurch gekennzeichnet, daß der Träger (15) mit zwei Leiterflächen (26, 27) versehen ist, die mit den jeweiligen Leiterelementen (16) verbunden sind.

3. Gehäuse gemäß Anspruch 2, dadurch gekennzeichnet, daß die kleinen Blöcke (25) mit den entsprechenden Anschlußleitungen der integrierten Schaltung verlötet sind.

4. Gehäuse gemäß Anspruch 1, 2 oder 3, dadurch gekennzeichnet, daß das Leiterelement (16) mit dem Wärmeabführelement (14) elektrisch verbunden ist.

5. Gehäuse gemäß Anspruch 4, dadurch gekennzeichnet, daß die Befestigung des Wärmeabführelementes (14) außerdem dessen elektrische Verbindung mit dem Leiterelement (16) umfaßt.

6. Gehäuse gemäß einem der Ansprüche 1 bis 5, dadurch gekennzeichnet, daß der Versteifungsrahmen (23) einen Deckel (21) trägt, der ein leitendes Plättchen (24) aufweist, welches das Wärmeabführelement (14) mit wenigstens einem Leiterelement (16) des Trägers (15) elektrisch verbindet.

7. Gehäuse gemäß Anspruch 6, dadurch gekennzeichnet, daß der Träger (15) über den Versteifungrahmen (23) und den Deckel (21) am Wäremabführelement (14) befestigt ist.

8. Gehäuse gemäß einem der Ansprüche 1 bis 7, dadurch gekennzeichnet, daß es außerdem auf Höhe der Leiterelemente (16) eine Entkopplung mittels Kodensatoren (29) umfaßt.

9. Gehäuse gemäß Anspruch 8, dadurch gekennzeichnet, daß der Deckel (21) Steckstellenpaare (30, 31) trägt, die jeweils für die Befestigung eines Entkopplungskondensators (29) vorgesehen sind, wobei die Steckstellen (30, 31) eines jeden Paares jeweils mit zwei Leiterelementen (16) des Trägers (15) verbunden sind.

10. Gehäuse gemäß Anspruch 9, dadurch gekennzeichnet, daß die Steckstellen (30, 31) durch zwei angrenzende Seiten von Leiterplättchen (32), die in den Ecken des Deckels (21) angeordnet sind und jeweils an einem Leiterelement (16) des Trägers (15) befestigt sind, gebildet werden.

11. Gehäuse gemäß einem der Ansprüche 1 bis 10, dadurch gekennzeichnet, daß jedes Leiterelement (16) eine den Träger (15) durchsetzende Säule ist.

12. Gehäuse gemäß Anspruch 11, dadurch gekennzeichnet, daß jede Säule (16) den Träger (15) durch ein Loch (17) durchsetzt und mit einem abgewinkelten Sockel (16a) versehen ist, dessen Unterseite zu den Enden der Anschlußleitungen (12) im wesentlichen koplanar ist.

13. Gehäuse gemäß einem der Ansprüche 1 bis 12, dadurch gekennzeichnet, daß die Anschlußleitungen (12) der integrierten Schaltung (10) durch wenigstens einen Isolierrahmen (33 - 35) in Position gehalten werden.

14. Gehäuse gemäß Anspruch 13, dadurch gekennzeichnet, daß ein Rahmen (35) die freien Enden der Anschlußleitungen (12) befestigt.

15. Gehäuse gemäß Anspruch 13, dadurch gekennzeichnet, daß ein Rahmen (33) Löcher (40) aufweist, die mit den Leiterelementen (16) zusammenwirken, um die Anschlußleitungen (12) der integrierten Schaltung (10) in bezug auf den Träger (15) zu positionieren.

16. Gehäuse gemäß Anspruch 13, dadurch gekennzeichnet, daß die integrierte Schaltung mittels Durchtrennung eines TAB- Bandes abgenommen wird.

17. Gehäuse gemäß einem der Ansprüche 1 bis 16, dadurch gekennzeichnet, daß ein biegsames Grenzschichtelement (20) mit guter Wärmeleitfähigkeit zwischen der Rückseite (10b) der integrierten Schaltung (10) und dem Wärmeabführelement (14) angeordnet ist.

18. Gehäuse gemäß Anspruch 17, dadurch gekennzeichnet, daß das Grenzschichtelement außerdem ein guter elektrischer Leiter ist.

## Claims

1. A package (36, 36') for an integration chip (10) provided with leads, the back (10b) of the integration chip (10) being connected to a heat dissipating element (14, 14') and the leads (12) of the integration chip (10) having free end portions comprising the output terminals of the package and inner portions affixed via an insulating support (15), characterized in that the support (15) is a rigid printed circuit board disposed facing the active face (10a) of the integration chip (10) and fixed to the heat dissipating element (14) via an electrically insulating bracing frame (23) surrounding the integration chip, and which has blocks (25) corresponding respectively with predetermined leads (12) of the integration chip (10) and connects the blocks (25) with at least one voltage supply source (V1, V2) external to the package, via at least one conductor element (16).

2. A package according to Claim 1, characterized in that the support (15) is provided with two conductor sheets (26,27) connected to respective conductor elements (16).

3. A package according to Claim 2, characterized in that the blocks (25) are soldered to the respective leads of the integration chip.

4. A package according to Claim 1, 2 or 3, characterized in that the conductor element (16) is electrically connected to the heat dissipating element (14).

5. A package according to Claim 4, characterized in that the attachment of the heat dissipating element (14) further comprises its electrical connection to the conductor element (16).

6. A package according to one of Claims 1 to 5, characterized in that the bracing frame (23) carries a cap (21) comprising a conductive foil (24) effecting electrical connection of the heat dissipating element (14) with at least one conductor element (16) of the support (15).

7. A package according to Claim 6, characterized in that the support (15) is fixed to the heat dissipating element (14) via the bracing frame (23) and the cap (21).

8. A package according to one of Claims 1 to 7, characterized in that it further comprises a decoupling by capacitors (29) at the level of the conductor elements (16).

9. A package according to Claim 8, characterized in that the cap (21) carries pairs of pads (30,31) each adapted for fixation of a decoupling capacitor (29), the pads (30, 31) of each pair being connected respectively to two conductor elements (16) of the support (15).

10. A package according to Claim 9, characterized in that the pads (30,31) are embodied by two adjacent sides of conductor plates (32) disposed at the corners of the cap (21) and each being affixed to one conductor element (16) of the support (15).

11. A package according to one of Claims 1 to 10, characterized in that each conductor element (16) is a column passing through the support (15).

12. A package according to Claim 11, characterized in that each column (16) passes through the support (15) in a hole (17) and is provided with a bent base (16a), the lower face of which is substantially coplanar with the ends of the leads (12).

13. A package according to one of Claims 1 to 12, characterized in that the leads (12) of the integration chip (10) are held in position by at least one insulating frame (33 - 35).

14. A package according to Claim 13, characterized in that a frame (35) fixes the free ends of the leads (12).

15. A package according to Claim 13, characterized in that a frame (33) comprises holes (40) cooperating with conductor elements (16) to position the leads (12) of the integration chip (10) with respect to the support (15).

16. A package according to Claim 13, characterized in that the integration chip is detached by cutting a TAB tape.

17. A package according to one of Claims 1 to 16, characterized in that a flexible interface element, which is a good thermal conductor (20) is arranged between the back (10b) of the integration chip (10) and the heat dissipating element (14).

18. A package according to Claim 17, characterized in that the interface element is also a good electrical conductor.

**FIG. 1**

**FIG. 2**

FIG.5

37

38

12  43  44

35

39

34  33  41  10  40  42

FIG.3

15

17

25

FIG.4

21  30  32

31

24

31

32  30  31  32

FIG. 6A    FIG. 6B    FIG. 6C    FIG. 6D

FIG. 6E    FIG. 6F    FIG. 6G    FIG. 6H

FIG. 7